(19) Europäisches Patentamt
European Patent Office
Office européen des brevets

(11) **EP 2 669 960 B1**

(12) **EUROPEAN PATENT SPECIFICATION**

(45) Date of publication and mention
of the grant of the patent:
**27.04.2016 Bulletin 2016/17**

(51) Int Cl.:
***H01L 31/048*** *(2006.01)*

(21) Application number: **12739536.6**

(86) International application number:
**PCT/KR2012/000572**

(22) Date of filing: **20.01.2012**

(87) International publication number:
**WO 2012/102540 (02.08.2012 Gazette 2012/31)**

(54) **PHOTOVOLTAIC CELL MODULE**

PHOTOVOLTAIKZELLENMODUL

MODULE DE CELLULE PHOTOVOLTAÏQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.01.2011 KR 20110007000
20.01.2012 KR 20120006992**

(43) Date of publication of application:
**04.12.2013 Bulletin 2013/49**

(73) Proprietor: **LG Chem, Ltd.
Youngdungpo-gu
Seoul 150-721 (KR)**

(72) Inventor: **KO, Min Jin
Daejeon 305-707 (KR)**

(74) Representative: **Goddar, Heinz J.
Boehmert & Boehmert
Anwaltspartnerschaft mbB
Patentanwälte Rechtsanwälte
Pettenkoferstrasse 20-22
80336 München (DE)**

(56) References cited:
**WO-A2-2010/051355      WO-A2-2010/147759
JP-A- 2002 261 310      JP-A- 2005 072 511
KR-A- 20080 072 834      KR-A- 20090 034 830**

**Description**

**[Field]**

The present invention relates to a photovoltaic cell module.

**[background]**

A photovoltaic cell is a semiconductor device capable of converting light into electricity. When exposed to light, the photovoltaic cell generates voltage and induces a subsequent electron flow. A magnitude of the induced electron flow is in proportion to an intensity of light collision on a photovoltaic cell junction formed on a surface of the photovoltaic cell.

A silicon wafer-based photovoltaic cell and a thin film photovoltaic cell are representative photovoltaic cells. The silicon wafer-based photovoltaic cell uses a wafer, which is a semiconductor material manufactured by using a single crystalline or polycrystalline ingot as an active layer. Further, the thin film photovoltaic cell uses, as an active layer, continuous layers of a semiconductor material deposited on a substrate or a ferroelectric substance by means of sputtering, chemical vapor deposition (CVD) or the like.

Both the wafer-based photovoltaic cell and the thin film photovoltaic cell are brittle and thus require a load carrying support member. The load carrying support member may be a light-transmissive member and an upper layer, such as a ferroelectric substance, provided at an upper part of the photovoltaic cell. The load carrying support member may be also a rear surface layer provided at a rear surface of the photovoltaic cell. A photovoltaic cell module may include both the upper layer and the rear surface layer at the same time and may be made of a rigid material such as a typical glass plate; a flexible material such as a metal film or a metal sheet; or a plastic material such as polyimide.

Typically, the rear surface layer is in the form of a rigid back skin to protect the rear surface of the photovoltaic cell module. Various materials which may be applied to the rear surface layer have been known publicly. By way of example, the materials may include a ferroelectric substance such as glass; an organic fluoro-based polymer such as ethylene tetrafluoroethylene (ETFE); or a poly(ethylene terephthalate) (PET)-based material. Such materials may be applied alone to the module or applied to the module after being coated with a silicon-based and/or oxygen-based material such as SiOx.

The photovoltaic cell module may include a single photovoltaic cell or a photovoltaic cell array that is a photovoltaic cell assembly, in which photovoltaic cells are electrically connected to each other on a ferroelectric substance and/or a substrate. The photovoltaic cell or the photovoltaic cell array is attached to the ferroelectric substance and/or the substrate and encapsulated by an encapsulant. The encapsulant is used to protect the photovoltaic cell from external environment and used to form an integrated module by layering the photovoltaic cells on the ferroelectric substance or the substrate.

Typically, the encapsulant is formed by using the same encapsulant or different encapsulants. An ethylene vinyl acetate (EVA)-based material or an epoxy-based material has been used generally as an encapsulant. Typically, such encapsulants are supplied in the form of films and layered on the photovoltaic cell, the ferroelectric substance and/or the substrate.

However, the conventional encapsulant made of the EVA-based material or the like has a low adhesive strength to glass and other parts of the module. Therefore, if the photovoltaic cell module is used for a long period of time, delamination among all of the layers of the module is readily induced, thereby inducing a decrease in efficiency of the module or corrosion due to moisture permeation. Further, the conventional encapsulant has a low UV resistance. Therefore, if it is used for a long period of time, decolorization or discoloration occurs, thereby resulting in a decrease in efficiency of the module. Furthermore, the conventional encapsulant has a problem of causing damage to the module due to stress generated during a curing process.

WO 2010/147759 A2 discloses a photovoltaic cell module comprising: an upper substrate; a lower substrate; and a photovoltaic cell that is encapsulated by a thermoplastic elastomer encapsulant between the upper substrate and the lower substrate, wherein the encapsulant comprises a filler.

**[Disclosure]**

**[Technical Problem]**

An object of the present invention is to provide a photovoltaic cell module.

**[Technical Solution]**

In order to achieve the above object, the present invention provides a photovoltaic cell module including: an upper substrate; a lower substrate; and a photovoltaic cell or a photovoltaic cell array encapsulated by an encapsulant between the upper substrate and the lower substrate, in which the encapsulant has a first layer including an aryl group-containing silicone resin, a second layer including light scattering particles and a third layer comprising a silicone resin or an ethylene vinyl acetate copolymer.

Preferred embodiments are disclosed in the sub-claims.

Hereinafter, the photovoltaic cell module according to the present invention will be described in detail.

A kind of an upper substrate which can be used in the present invention is not particularly limited and a typical material publicly known in the art may be used without limitation. Typically, as the upper substrate of the photovoltaic cell module, a substrate, such as a glass substrate; a fluoro-based polymer sheet; a cyclic polyolefin-based polymer sheet; a polycarbonate-based polymer sheet; an acryl-based polymer sheet; a polyamide-based polymer sheet; or a polyester-based polymer sheet having an excellent light transmission property, electric insulation property, mechanical strength, physical strength or chemical strength has been used, but the scope of the present invention is not limited thereto. In the present invention, a thickness of the upper substrate is not particularly limited and may be selected within a typical range.

Further, a kind of a lower substrate which can be used in the present invention is not particularly limited and a material typically used in the art may be used. Typically, as the lower substrate, a sheet, such as a plate or foil made of metal such as aluminum; a fluoro-based polymer sheet; a cyclic polyolefin-based polymer sheet; a polycarbonate-based polymer sheet; an acryl-based polymer sheet; a polyamide-based polymer sheet; or a polyester-based polymer sheet having weatherability, a layered sheet including two or more sheets of the above-described sheets or a complex sheet including the above-described sheets layered with a barrier film has been used, but the scope of the present invention is not limited thereto. In the present invention, a thickness of the lower substrate is not particularly limited and may be controlled within a typical range.

Furthermore, a kind of the photovoltaic cell or the photovoltaic cell array encapsulated by the encapsulant between the upper substrate and the lower substrate in the photovoltaic cell module of the present invention is not particularly limited. In the present invention, the photovoltaic cell or the photovoltaic cell array may include crystalline silicon such as single crystalline or polycrystalline silicon; amorphous silicon having a single junction type structure, a tandem structure or the like; and a compound semiconductor such as GaAs, InP, CdTe or $CuInSe_2$ and may include a polycrystalline silicon-based thin film, an amorphous silicon-based thin film or a hybrid material of the polycrystalline silicon-based thin film and the amorphous silicon-based thin film if necessary, but the present invention is not limited thereto.

The photovoltaic cell module of the present invention includes the encapsulant encapsulating the photovoltaic cell or the photovoltaic cell array provided between the upper substrate and the lower substrate. In the present invention, the encapsulant has a multilayered structure including a first layer including an aryl group-containing silicone resin and a second layer including light scattering particles. In the present invention, the encapsulant has a multilayered structure further including a third layer in addition to the first layer and the second layer.

In the present invention, positions of the first layer and the second layer included in the encapsulant are not particularly limited. In the present invention, by way of example, the first layer containing the silicone resin may be an upper layer of the encapsulant and the second layer containing the light scattering particles may be a lower substrate of the encapsulant. Since the encapsulant has this structure, the first layer positioned as the upper layer shows excellent light stability and even if the module is used for a long period of time, it is possible to prevent occurrence of decolorization or discoloration. Further, the second layer positioned as the lower layer scatters or reflects light of the sun, and thus it is possible to improve efficiency of the module. In the present invention, preferably, the second layer containing the light scattering particles may serve as the lower layer of the encapsulant and may be provided under the photovoltaic cell or the photovoltaic cell array while not being in contact with the photovoltaic cell or the photovoltaic cell array in consideration of prevention of damage to the photovoltaic cell or the photovoltaic cell array.

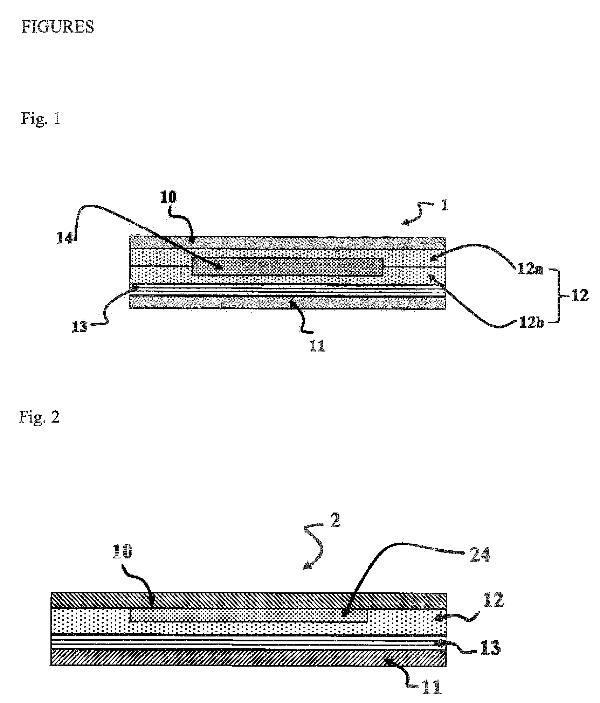

FIG. 1 illustrates an example of a photovoltaic cell module according to the present invention. As illustrated in FIG. 1, a photovoltaic cell module 1 of the present invention may include an upper substrate 10; a lower substrate 11; a photovoltaic cell or photovoltaic cell array 14 provided between the upper substrate 10 and the lower substrate 11; and encapsulants 12 and 13 that encapsulate the photovoltaic cell or photovoltaic cell array 14. If the photovoltaic cell module 1 of the present invention has a structure as depicted in Fig. 1, the photovoltaic cell or photovoltaic cell array 14 may contain a silicon-based material. Further, in the photovoltaic cell module 1 having the structure as depicted in FIG. 1, a first layer included in the encapsulant may be one of two layers 12a and 12b that encapsulate the photovoltaic cell or photovoltaic cell array 14 and may include both the layers 12a and 12b if necessary. Furthermore, a second layer containing light scattering particles may be formed as a lower layer 13 of the encapsulants while not being in contact with the photovoltaic cell or photovoltaic cell array 14 and may be in contact with the lower substrate 11 if necessary.

FIG. 2 illustrates another example of a photovoltaic cell module 2 according to the present invention. As illustrated in FIG 2, the photovoltaic cell module 2 of the present invention may include an upper substrate 10; a lower substrate 11; a photovoltaic cell or photovoltaic cell array 24 provided between the upper substrate 10 and the lower substrate 11; and encapsulants 12 and 13 that encapsulate the photovoltaic cell or photovoltaic cell array 24. In the photovoltaic cell module 2 having a structure as depicted in FIG. 2, the photovoltaic cell or photovoltaic cell array 24 may be a compound semiconductor layer. Further, in the photovoltaic cell module 2 having the structure as depicted in FIG. 2, the encapsulants may include a first layer 12 that encapsulates the photovoltaic cell or photovoltaic cell array 24 and a second layer formed as a lower layer 13 of the encapsulants while not being in contact with the photovoltaic cell or photovoltaic cell array 24.

A kind of an aryl group-containing silicone resin included in the first layer of the encapsulants of the present invention is not particularly limited as long as it is a material having a high adhesive strength to other parts of the module, excellent light stability, wet endurance, durability, and weatherability.

In the present invention, it is preferable to use, particularly, an aryl group-containing silicone resin satisfying a condition of the following General Formula 1 as the first layer.

$$[\text{General Formula 1}]$$

$$X \geq 0.15$$

In General Formula 1, X represents an average molar ratio (aryl groups/silicon atoms) of the total aryl groups included in the aryl group-containing silicone resin with respect to the total silicon atoms included in the aryl group-containing silicone resin.

In the present invention, X may be preferably 0.2 or more and more preferably 0.3 to 0.7.

In the present invention, by controlling the average molar ratio to be in the above-described range, it is possible to supply the encapsulants having excellent light extraction efficiency, adhesive strength to other parts of the module, wet endurance, and durability. In particular, if the average molar ratio exceeds 0.7, viscosity is increased and processability is decreased, and after a curing process, impact resistance of the encapsulants may be deteriorated.

Preferably, an aryl group contained in the silicone resin of the present invention may be a phenyl group.

In one example of the present invention, the aryl group-containing silicone resin may be a resin which can be represented by an average composition formula of the following Chemical Formula 1 and may contain a siloxane unit represented by the following Chemical Formula 2 or the following Chemical Formula 3.

[Chemical Formula 1] $\quad (R^1R^2R^3SiO_{1/2})_a(R^4R^5SiO_{2/2})_b(R^6SiO_{3/2})_c(SiO_{4/2})_d$

[Chemical Formula 2] $\quad (R^7R^8SiO_{2/2})$

[Chemical Formula 3] $\quad (R^9SiO_{3/2})$

In Chemical Formula 1 to Chemical Formula 3, $R^1$ to $R^6$ are substituents directly bound to a silicon atom and each independently represent hydrogen, an alkyl group, an aryl group, a hydroxy group, an epoxy group, an acryl group, an isocyanate group, an alkoxy group or an alkenyl group. At least one or more of $R^1$ to $R^6$ represent an aryl group, and a is between 0 and 0.6, b is between 0 and 0.8, c is between 0 and 0.8, d is between 0 and 0.4, a+b+c+d is 1, $R^7$ and $R^8$ each independently represent an alkyl group or an aryl group, and $R^9$ represents an aryl group. However, b and c are not 0 simultaneously and at least one of $R^7$ and $R^8$ represents an aryl group.

In the present invention, the silicone resin can be represented by the average composition formula of Chemical Formula 1 when the encapsulants include a single silicone resin represented by the average composition formula of Chemical Formula 1 and when the encapsulants include multiple silicone resins and an average composition of the silicone resins can be represented by Chemical Formula 1.

In the present invention, the silicone resin represented by the average composition formula of Chemical Formula 1 includes one or more siloxane units selected from a monofunctional siloxane unit (M unit) represented by $(R^1R^2R^3SiO_{1/2})$, a difunctional siloxane unit (D unit) represented by $(R^4R^5SiO_{2/2})$, a trifunctional siloxane unit (T unit) represented by $(R^6SiO_{3/2})$, and a tetrafunctional siloxane unit (Q unit) represented by $(SiO_{4/2})$. At least one siloxane unit of the D unit and the T unit may be represented by Chemical Formula 2 or Chemical Formula 3.

In the average composition formula of Chemical Formula 1, $R^1$ to $R^6$ are substituents directly bound to a silicon atom and independently represent hydrogen, an alkyl group, an aryl group, a hydroxy group, an epoxy group, an acryl group, an isocyanate group, an alkoxy group or an alkenyl group in order to improve a curing reaction and an adhesive strength, and preferably, $R^1$ to $R^6$ may be an alkyl group or an aryl group.

In Chemical Formula 1 of the present invention, an alkyl group may be a linear, branched or cyclic alkyl group having 1 to 12 carbon atoms, preferably 1 to 8 carbon atoms and more preferably 1 to 4 carbon atoms. To be specific, the alkyl group may be a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group or a decyl group, and preferably, the alkyl group may be a methyl group, but the present invention is not limited thereto.

Further, in Chemical Formula 1 of the present invention, an aryl group may be an aryl group having 6 to 18 carbon atoms and preferably 6 to 12 carbon atoms and may be substituted or unsubstituted with an alkyl group or a hydroxy group. To be specific, the aryl group may be a phenyl group, a tolyl group, a xylyl group or a naphthyl group, and preferably, the aryl group may be a phenyl group, but the present invention is not limited thereto.

Furthermore, in Chemical Formula 1 of the present invention, an alkoxy group may be a linear, branched or cyclic alkoxy group having 1 to 12 carbon atoms, preferably 1 to 8 carbon atoms and more preferably 1 to 4 carbon atoms. To be specific, the alkoxy group may be a methoxy group, an ethoxy group, a propoxy group, an isopropoxy group, a butoxy group, an isobutoxy group or a tert-butoxy group, and preferably, the alkoxy group may be a methoxy group or an ethoxy group, but the present invention is not limited thereto.

Moreover, in Chemical Formula 1 of the present invention, an alkenyl group may be a linear or branched alkenyl group having 2 to 12 carbon atoms, preferably 2 to 8 carbon atoms and more preferably 2 to 4 carbon atoms. To be specific, the alkenyl group may be a vinyl group, an allyl group, a propenyl group, an isopropenyl group, a butenyl group, a hexenyl group, a cylcohexenyl group, an octenyl group or a decenyl group, and preferably, the alkenyl group may be a vinyl group or an allyl group, but the present invention is not limited thereto.

In the average composition formula of Chemical Formula 1 of the present invention, a, b, c and d represent a mole fraction of the siloxane units, respectively, and the total sum of a, b, c and d is 1 with the proviso that b and c not be 0 simultaneously. To be specific, in the average composition formula of Chemical Formula 1, a may be between 0 and 0.6 and preferably between 0 and 0.5, b may be between 0 and 0.8 and preferably between 0 and 0.7, c may be between 0 and 0.8 and preferably between 0 and 0.7, and d is between 0 and 0.4 and preferably between 0 and 0.2. In the present invention, by controlling the mole fraction of the M, D, T, and Q units in the silicone resin as described above, it is possible to supply the encapsulants having excellent adhesive strength to other parts of the module, wet endurance, weatherability, light stability, hardness, and UV resistance.

In the present invention, the silicone resin may include at least one or more aryl groups in a molecular structure as represented by the average composition formula of Chemical Formula 1 in consideration of properties such as light extraction efficiency, weatherability, wet endurance, and hardness, and preferably, the aryl group may be a phenyl group.

In the silicone resin of the present invention, preferably, the aryl group may be included in the D unit or the T unit, and more preferably, all the aryl groups contained in the silicone resin represented by the average composition formula of Chemical Formula 1 may be included in the D unit and/or the T unit. Further, the D unit and the T unit may have specific structures, i.e. the structures represented by Chemical Formula 2 and Chemical Formula 3.

In Chemical Formula 2 and Chemical Formula 3 of the present invention, an alkyl group may be a linear, branched or cyclic alkyl group having 1 to 12 carbon atoms and preferably 1 to 8 carbon atoms and more preferably 1 to 4 carbon atoms. To be specific, the alkyl group may be a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group or a decyl group, and preferably, the alkyl group may be a methyl group, but the present invention is not limited thereto.

Further, in Chemical Formula 2 and Chemical Formula 3 of the present invention, an aryl group may be an aryl group having 6 to 18 carbon atoms and preferably 6 to 12 carbon atoms and may be substituted or unsubstituted with an alkyl group or a hydroxy group. To be specific, the aryl group may be a phenyl group, a tolyl group, a xylyl group or a naphthyl group, and preferably, the aryl group may be a phenyl group, but the present invention is not limited thereto.

In the present invention, a unit of Chemical Formula 2 may be a difunctional siloxane unit (D unit) included in the silicone resin and preferably a siloxane unit represented by Chemical Formula 4 or Chemical Formula 5.

$$\text{[Chemical Formula 4]} \qquad (MePhSiO_{2/2})$$

$$\text{[Chemical Formula 5]} \qquad (Ph2SiO_{2/2})$$

In Chemical Formula 4 and Chemical Formula 5, Me represents a methyl group and Ph represents a phenyl group.

Further, a unit of Chemical Formula 3 of the present invention may be a trifunctional siloxane unit (T unit) included in the silicone resin and preferably a siloxane unit represented by Chemical Formula 6.

$$\text{[Chemical Formula 6]} \qquad (PhSiO_{3/2})$$

In Chemical Formula 6, Ph represents a phenyl group.

The silicone resin represented by the average composition formula of Chemical Formula 1 of the present invention may have a weight average molecular weight ($M_w$) in the range of from 500 to 200,000 and preferably from 1,000 to 200,000. In the present invention, by controlling the weight average molecular weight as described above, it is possible to maintain excellent workability and processability during an encapsulation process and also possible to supply the encapsulants having excellent hardness, light stability, and durability. The term "weight average molecular weight" used in the present invention means a polystyrene conversion value measured by means of gel permeation chromatography (GPC).

In the present invention, the aryl group-containing silicone resin included in the first layer is not particularly limited as long as it satisfies the above-described conditions. To be specific, the aryl group-containing silicone resin of the present invention may be represented by, but is not limited to, average composition formulas as follows.

$(ViMe_2SiO_{1/2})_2(MePhSiO_{2/2})_{30}$

$(ViMe_2SiO_{1/2})_2(ViMeSiO_{2/2})_3(MePhSiO_{2/2})_{30}(Me_2SiO_{2/2})_{30}$

$(ViMe_2SiO_{1/2})_2(ViMeSiO_{2/2})_5(Ph_2SiO_{2/2})_{20}(Me_2SiO_{2/2})_{40}$

$(ViMe_2SiO_{1/2})_2(MeEpSiO_{2/2})_5(Ph_2SiO_{2/2})_{10}(Me_2SiO_{2/2})_{10}$

$(ViMe_2SiO_{1/2})_2(Ph_2SiO_{2/2})_{15}(Me_2SiO_{2/2})_{15}(MeEpSiO_{2/2})5$

$(ViMe_2SiO_{1/2})_3(PhSiO_{3/2})_5$

$(ViMe_2SiO_{1/2})_3(Me_2SiO_{2/2})_5(PhSiO_{3/2})_{10}(MeSiO_{3/2})_2$

$(ViMe_2SiO_{1/2})_3(MeEpSiO_{2/2})_5(PhSiO_{3/2})_{10}$

$(HMe_2SiO_{1/2})_3(PhSiO_{3/2})_{10}$

$(HMe_2SiO_{1/2})_3(MeEpSiO_{2/2})_5(PhSiO_{3/2})_{10}$

$(HMe_2SiO_{1/2})_2(Ph_2SiO_{2/2})_{1.5}$

$(HMe_2SiO_{1/2})_2(Ph_2SiO_{2/2})_5(Me_2SiO_{2/2})_5$

$(PhSiO_{3/2})_{10}(MePhSiO_{2/2})_{10}(Me_2SiO_{2/2})_{10}$

$(PhSiO_{3/2})_5(EpMeSiO_{2/2})_2(Me_2SiO_{2/2}))_{10}$

$(PhSiO_{3/2})_5(AcSiO_{3/2})_5(Me_2SiO_{2/2})_{10}$

$(AcSiO_{3/2})_5(Me_2SiO_{2/2})_{10}(Ph_2SiO_{2/2})_5$

Herein, Vi, Me, Ph, Ac and Ep represent a vinyl group, a methyl group, a phenyl group, an acryl group, and an epoxy group, respectively.

In the present invention, a method for forming the encapsulant including the above-described silicone resin is not particularly limited. In the present invention, the encapsulant including the above-described silicone resin may be formed by appropriately employing various materials publicly known in the art, such as an addition-curable silicon composition; a condensation- or polycondensation-curable silicon composition; an ultraviolet-curable silicon composition; or a peroxide vulcanized silicon composition, and it is preferable to use an addition-curable silicon composition; a condensation- or polycondensation-curable silicon composition; or an ultraviolet-curable silicon composition, but the present invention is not limited thereto.

With an addition-curable silicon composition, a silicone resin can be formed through a hydrosilylation reaction. In case of using the addition-curable silicon composition, an organic silicon compound containing a hydrogen atom bound to a silicon atom (a Si-H group) and an organic silicon compound containing an alkenyl group bound to a silicon atom are allowed to react with each other under a catalyst, and thus a silicone resin can be manufactured.

Further, in case of using the condensation- or polycondensation-curable silicon composition, organic silane or siloxane having a hydrolysable functional group such as - Cl, -OCH$_3$, -OC(O)CH$_3$, -N(CH$_3$)$_2$, -NHCOCH$_3$ or -SCH$_3$ is

used in a hydrolysis reaction or a condensation reaction, and thus a silicone resin can be manufactured.

Furthermore, in case of using the ultraviolet-curable silicon composition, a silicon compound such as silane or siloxane having a functional group which can be polymerized by ultraviolet light, for example, (meth)acryl or vinyl or its hydrolysate is used in a hydrolysis reaction or a condensation reaction, and thus a silicone resin can be manufactured. Otherwise, ultraviolet light is radiated to the silicon compound or its hydrolysate, and thus a silicone resin can be manufactured.

In the pertinent art, various compositions, such as an addition-curable silicon composition; a condensation- or polycondensation-curable silicon composition; or an ultraviolet-curable silicon composition, which can be selected depending on a composition of a required silicone resin, and conditions for manufacturing a silicone resin by using such compositions or reaction additives have been publicly known. In the present invention, the first layer including the silicone resin represented by Chemical Formula 1 can be formed by appropriately employing the above-described methods.

The encapsulant of the present invention also includes the second layer including the light scattering particles. As described above, the second layer of the present invention is provided under the photovoltaic cell or the photovoltaic cell array, and thus it is possible to further improve efficiency of the photovoltaic cell module.

In the present invention, "the light scattering particles" are capable of reflecting or scattering light incident on the module. To be specific, the particles have a refractive index of 1.5 or more with respect to light having a wavelength of 450 nm. The refractive index can be obtained by preparing a mixture of a resin having a well-known refractive index and a certain amount of the light scattering particles, forming a coating film with the mixture, and measuring a refractive index of the coating film by using an ellipsometer or an Abbe refractometer. In the present invention, the second layer is made of the particles having the above-described refractive index, and thus it is possible to further improve efficiency of the photovoltaic cell module.

In the present invention, a shape of the light scattering particles is not particularly limited. By way of example, the light scattering particles may have various shapes including a spherical shape or a polygonal shape or may be amorphous. Further, in the present invention, the light scattering particles may have an average particle diameter in the range of from 40 nm to 100,000 nm, preferably from 40 nm to 50,000 nm and more preferably from 40 nm to 10,000 nm. In the present invention, if the average particle diameter is smaller than 40 nm, the light scattering particles cannot be dispersed uniformly in the second layer due to agglomeration between the particles, and if the average particle diameter is greater than 100,000 nm, processability and an adhesive property of the second layer may be deteriorated. That is, in the present invention, by using the particles having the above-described average particle diameter, it is possible to improve a light scattering property and dispersibility of the particles, so that the second layer may have excellent effects.

A kind of light scattering particles which can be used in the present invention is not particularly limited as long as the light scattering particles have the above-described properties. That is, in the present invention, various inorganic particles having the above-described properties may be used. By way of example, the light scattering particles may include one or more kinds of inorganic particles selected from the group consisting of glass beads, alumina, titanium oxide, zirconium oxide, cerium oxide, hafnium oxide, niobium pentoxide, tantalum pentoxide, indium oxide, tin oxide, indium tin oxide, zinc oxide, silicon-based particles, zinc sulfide, barium sulfate, calcium carbonate, and magnesium oxide, but the present invention is not limited thereto.

The second layer of the present invention may contain the above-described light scattering particles in the amount of from 0.1 parts by weight to 50 parts by weight and preferably from 0.1 parts by weight to 30 parts by weight relative to 100 parts by weight of the following base resin of the second layer. In the present invention, if the light scattering particles are contained in an amount of less than 0.1 parts by weight, light reflection and refraction effects may be deteriorated, and if the light scattering particles are contained in an amount of more than 50 parts by weight, processability and an adhesive property of the second layer may be deteriorated.

In the present invention, the second layer may further include the base resin which constitutes the second layer together with the light scattering particles.

A kind of a base resin which can be used herein is not particularly limited. By way of example, the base resin may be a resin typically used as an encapsulant such as an EVA-based resin, an epoxy resin or a silicone resin.

In the present invention, the second layer may include an aryl group-containing silicone resin and preferably a phenyl-group-containing silicone resin as the base resin like the first layer.

In an example of the present invention, an aryl group-containing silicone resin constituting the second layer may satisfy a condition of General Formula 2.

[General Formula 2]

$$Y \geq 0.15$$

In General Formula 2, Y represents an average molar ratio (aryl groups/silicon atoms) of the total aryl groups included in the aryl group-containing silicone resin with respect to the total silicon atoms included in the aryl group-containing silicone resin of the second layer.

In the present invention, Y may be preferably 0.2 or more and more preferably 0.3 to 0.7.

In the present invention, by controlling the average molar ratio of the aryl group in the silicone resin included in the second layer to be in the above-described range, it is possible for the second layer to have an excellent water and moisture prevention effect. In particular, if the average molar ratio exceeds 0.7, viscosity is increased and processability is decreased, and after a curing process, impact resistance of the encapsulants may be deteriorated.

To be more specific, in the present invention, the silicone resin constituting the second layer may be a silicone resin represented by an average composition formula of Chemical Formula 7.

[Chemical Formula 7] $\quad (R^{10}R^{11}R^{12}SiO_{1/2})_e(R^{13}R^{14}SiO_{2/2})_f(R^{15}SiO_{3/2})_g(SiO_{4/2})_h$

In Chemical Formula 7, $R^{10}$ to $R^{15}$ are substituents directly bound to a silicon atom and independently represent hydrogen, an alkyl group, an aryl group, a hydroxy group, an epoxy group, an acryl group, an isocyanate group, an alkoxy group or an alkenyl group. At least one or more of $R^{10}$ to $R^{15}$ represent an aryl group, e is between 0 and 0.6, f is between 0 and 0.8, g is between 0 and 0.8, h is between 0 and 0.4, and e+f+g+h is 1.

In the present invention, the silicone resin constituting the second layer can be represented by the average composition formula of Chemical Formula 7 when a single silicone resin included in the second layer is represented by Chemical Formula 7 and when multiple silicone resins are included in the second layer, an average composition of the silicone resins can be represented by Chemical Formula 7.

In the present invention, specific kinds and examples of $R^{10}$ to $R^{15}$ of the average composition formula of Chemical Formula 7 are the same as those of $R^1$ to $R^6$.

Further, in Chemical Formula 7 of the present invention, e, f, g and h represent mole fractions of the M, D, T, and Q units constituting the silicone resin, respectively, e may be between 0 and 0.6 and preferably between 0 and 0.5, f may be between 0 and 0.8 and preferably between 0 and 0.7, g may be between 0 and 0.8 and preferably between 0 and 0.7, and h is between 0 and 0.4 and preferably between 0 and 0.2. In the present invention, by controlling the mole fractions of the M, D, T, and Q units in the silicone resin of the second layer as described above, it is possible to supply the encapsulants having excellent adhesive strength to other parts of the module, wet endurance, weatherability, light stability, hardness, and UV resistance.

Like the silicone resin of the first layer, in the silicone resin of the second layer of the present invention, preferably, the aryl group may be included in the D unit or the T unit, and more preferably, all the aryl groups contained in the silicone resin represented by the average composition formula of Chemical Formula 7 may be included in the D unit represented by Chemical Formula 8 and/or the T unit represented by Chemical Formula 9.

[Chemical Formula 8] $\qquad R^{16}R^{17}SiO_{2/2}$

[Chemical Formula 9] $\qquad R^{18}SiO_{3/2}$

In Chemical Formula 8 and Chemical Formula 9, $R^{16}$ and $R^{17}$ independently represent an alkyl group or an aryl group, and at least one of $R^{16}$ and $R^{17}$ represents an aryl group. Further, $R^{18}$ represents an aryl group.

In Chemical Formula 8 and Chemical Formula 9, specific examples and preferable examples of the alkyl group and the aryl group are the same as those of Chemical Formula 2 and Chemical Formula 3.

Preferably, a siloxane unit of Chemical Formula 8 of the present invention may be a difunctional siloxane unit represented by Chemical Formula 10 or Chemical Formula 11, and preferably, a siloxane unit of Chemical Formula 9 may be a trifunctional siloxane unit represented by Chemical Formula 12.

[Chemical Formula 10] $\qquad (MePhSiO_{2/2})$

[Chemical Formula 11] $\qquad (Ph_2SiO_{2/2})$

[Chemical Formula 12] $\qquad (PhSiO_{3/2})$

In Chemical Formula 10 to Chemical Formula 12, Me represents a methyl group and Ph represents a phenyl group.

The silicone resin represented by the average composition formula of Chemical Formula 7 of the present invention may have a weight average molecular weight ($M_w$) in the range of from 500 to 200,000 and preferably from 1,000 to 100,000. In the present invention, by controlling the weight average molecular weight as described above, it is possible to maintain excellent workability and processability during an encapsulation process and also possible to supply the encapsulants having excellent hardness, light stability, and durability.

In the present invention, the aryl group-containing silicone resin included in the second layer is not particularly limited as long as it satisfies the above-described conditions. To be specific, the aryl group-containing silicone resin of the present invention may be represented by, but is not limited to, average composition formulas as follows.

$(ViMe_2SiO_{1/2})_2(MePhSiO_{2/2})_{30}$

$(ViMe_2SiO_{1/2})_2 (MePhSiO_{2/2})_{30}(Me_2SiO_{2/2})_{30}$

$(ViMe_2SiO_{1/2})_2(ViMeSiO_{2/2})_5(Ph_2SiO_{2/2})_{20}(Me_2SiO_{2/2})_{40}$

$(ViMe_2SiO_{1/2})_2(MeEpSiO_{2/2})_5(Ph_2SiO_{2/2})_{10}(Me_2SiO_{2/2}))_{10}$

$(ViMe_2SiO_{1/2})_2(Ph_2SiO_{2/2})_5(Me_2SiO_{2/2})_{15}(MeEpSiO_{2/2})_5$

$(ViMe_2SiO_{1/2})_3(PhSiO_{3/2})_5$

$(ViMe_2SiO_{1/2})_3(Me_2SiO_{2/2})_5(PhSiO_{3/2})_{10}(MeSiO_{3/2})_2$

$(ViMe_2SiO_{1/2})_3(MeEpSiO_{2/2})_5(PhSiO_{3/2})_{10}$

$(HMe_2SiO_{1/2})_3(PhSiO_{3/2})_{10}$

$(HMe_2SiO_{1/2})_3(MeEpSiO_{2/2})_5(PhSiO_{3/2})_{10}$

$(HMe_2SiO_{1/2})_2(Ph_2SiO_{2/2})_{1.5}$

$(HMe_2SiO/_{1/2})_2(Ph_2SiO_{2/2})_5(Me_2SiO_{2/2})_5$

$(PhSiO_{3/2})_{10}(MePhSiO_{2/2})_{10}(Me_2SiO_{2/2})_{10}$

$(PhSiO_{3/2})_5(EpMeSiO_{2/2})_2(Me_2SiO_{2/2})_{10}$

$(PhSiO_{3/2})_5(AcSiO_{3/2})_5(Me_2SiO_{2/2})_{10}$

$(AcSiO_{3/2})_5(Me_2SiO_{2/2})_{10}(Ph_2SiO_{2/2})_5$

Herein, Vi, Me, Ph, Ac and Ep represent a vinyl group, a methyl group, a phenyl group, an acryl group, and an epoxy group, respectively.

In the present invention, a method for forming the encapsulant including the above-described silicone resin is not particularly limited. By way of example, in the present invention, the second layer may be formed by using an addition-curable silicon composition; a condensation- or polycondensation-curable silicon composition; an ultraviolet-curable silicon composition; or a peroxide vulcanized silicon composition which can be selected depending on a composition of a required silicone resin in a similar manner to the first layer.

In the present invention, a method for manufacturing the photovoltaic cell module including the above-described components is not particularly limited and various methods publicly known to those skilled in the art may be employed without limitation.

By way of example, in the present invention, an encapsulant material may be formed in a high-temperature fusible sheet or a liquid and applied to an appropriate encapsulation method in consideration of a required layer structure, so that a photovoltaic cell module can be manufactured. In particular, it is appropriate to manufacture a photovoltaic cell module by directly coating the liquid encapsulant material in view of manufacturing costs and process efficiency.

The above term "high-temperature fusible sheet" means a sheet-shaped body made of the encapsulant material. The high-temperature fusible sheet stays in an uncured or partially cured state before use, and its strength and flow resistance are increased at room temperature. The high-temperature fusible sheet can be converted into a fluent substance having a low viscosity by heating and can also be a substance having a high viscosity by cooling. In the pertinent art, methods for manufacturing the high-temperature fusible sheet by using the above-described materials have been publicly known.

If the high-temperature fusible sheet is used in the present invention, depending on a required photovoltaic cell module structure, a photovoltaic cell module can be manufactured by layering an upper layer, a lower layer, a photovoltaic cell or a photovoltaic cell array with the high-temperature fusible sheet and hot-pressing them.

Further, if the liquid material is used in the present invention, a photovoltaic cell module can be manufactured by directly coating and then curing the liquid material on a target position during a process.

However, in the present invention, a method for manufacturing a module by using the above-described encapsulant material is not limited to the above methods.

**[Effect of the Invention]**

The present invention can provide a photovoltaic cell module with excellent durability capable of preventing separation of layers constituting the module and decolorization and discoloration of an encapsulant, caused by long-term use or moisture permeation. In addition, the present invention can provide a photovoltaic cell module with excellent power generation efficiency.

**[Description of Drawings]**

FIGS. 1 and 2 show schematics of illustrative embodiments of cross sectional views respectively illustrating photovoltaic cell modules of the present invention.

[ILLUSTRATIVE EMBODIMENT]

Hereinafter, the present invention will be explained in detail with reference to examples according to the present invention and a comparative example not according to the present invention. The scope of the present invention is not limited to the following examples.

**Preparation Example 1: Preparation of encapsulant composition (1)**

100 g of a polymer compound having a resin structure represented by $(ViMe_2SiO_{1/2})_2(ViMeSiO_{2/2})_5(Ph_2SiO_{2/2})_{20}(Me_2SiO_{2/2})_{40}$, 3 g of a polymer compound having a resin structure represented by $(ViMe_2SiO_{1/2})_2(MeEpSiO_{2/2})_5(Ph_2SiO_{2/2})_{10}(Me_2SiO_{2/2})_{10}$, 50 g of a polymer compound having a resin structure represented by $(ViMe_2SiO_{1/2})_{2.5}(PhSiO_{3/2})_7$, and 20 g of a polymer compound having a resin structure represented by $(HMe_2SiO_{1/2})_2(Ph_2SiO_{2/2})_{1.5}$ were mixed and a platinum(0)-1,3-divinyl-1,1,3-tetramethyldisiloxane solution was added thereto as a platinum-based catalyst such that the amount of Pt(0) could be 10 ppm. Thus, an encapsulant composition (1) was prepared.

**Preparation Example 2: Preparation of encapsulant composition (2)**

100 g of a polymer compound having a resin structure represented by $(ViMe_2SiO_{1/2})_2(ViMeSiO_{2/2})_5(Ph_2SiO_{2/2})_{20}(Me_2SiO_{2/2})_{40}$, 3 g of a polymer compound having a resin structure represented by $(ViMe_2SiO_{1/2})_2(MeEpSiO_{2/2})_5(Ph_2SiO_{2/2})_{10}(Me_2SiO_{2/2})_{10}$, 50 g of a polymer compound having a resin structure represented by $(ViMe_2SiO_{1/2})_{2.5}(PhSiO_{3/2})_7$, and 20 g of a polymer compound having a resin structure represented by $(HMe_2SiO_{1/2})_2(Ph_2SiO_{2/2})_{1.5}$ were mixed and a platinum(0)-1,3-divinyl-1,1,3,3-tetramethyldisiloxane solution was added thereto as a platinum-based catalyst such that the amount of Pt(0) could be 10 ppm and 20 g of $TiO_2$ particles having an average diameter of 3,000 nm was added. Thus, an encapsulant composition (2) was prepared.

**Preparation Example 3: Preparation of encapsulant composition (3)**

100 g of a polymer compound having a resin structure represented by $(ViMe_2SiO_{1/2})_2(Ph_2SiO_{2/2})_{10}(Me_2SiO_{2/2})_{40}$, 3 g of a polymer compound having a resin structure represented by $(ViMe_2SiO_{1/2})_2(MeEpSiO_{2/2})_5(Ph_2SiO_{2/2})_{10}(Me_2SiO_{2/2})_{10}$, 50 g of a polymer compound having a resin structure represented by $(ViMe_2SiO_{1/2})_2(Me_2SiO_{2/2})_5(PhSiO_{3/2})_7$, and 30 g of a polymer compound having a resin structure represented by $(HMe_2SiO_{1/2})_2(PhMeSiO_{2/2})_{1.5}$ were mixed and a platinum(0)-1,3-divinyl-1,1,3-tetramethyldisiloxane solution was added thereto as a platinum-based catalyst such that the amount of Pt(0) could be 5 ppm. Thus, an encapsulant composition (3) was prepared.

**Preparation Example 4: Preparation of encapsulant composition (4)**

100 g of a polymer compound having a resin structure represented by $(ViMe_2SiO_{1/2})_2(Ph_2SiO_{2/2})_{10}(Me2SiO_{2/2})_{40}$, 3 g of a polymer compound having a resin structure represented by $(ViMe_2SiO_{1/2})_2(MeEpSiO_{2/2})_5(Ph_2SiO_{2/2})_{10}(Me_2SiO_{2/2})_{10}$, 50 g of a polymer compound having a resin structure represented by $(ViMe_2SiO_{1/2})_2(Me_2SiO_{2/2})_5(PhSiO_{3/2})_7$, and 30 g of a polymer compound having a resin structure represented by $(HMe_2SiO_{1/2})_2(PhMeSiO_{2/2})_{1.5}$ were mixed and a platinum(0)-1,3-divinyl-1,1,3-tetramethyldisiloxane solution a was added thereto s a platinum-based catalyst such that the amount of Pt(0) could be 5 ppm and 20 g of $TiO_2$ particles having an average diameter of 3,000 nm was added. Thus, an encapsulant composition (4) was prepared.

**<Example 1>**

The encapsulant composition (1) was coated on a glass plate as an upper substrate and cured at a temperature of 100 °C for one (1) hour so as to form an upper layer of a first layer of an encapsulant. Then, a photovoltaic cell device was placed on the upper layer of the first layer and coated again with the encapsulant composition (1). Thereafter, the encapsulant composition (2) was coated thereon and cured at a temperature of 150 °C for one (1) hour so as to form a lower layer of the first layer and a second layer. Then, a fluoro-based polymer sheet was hot-pressed onto the second layer as a lower substrate. Thus, a photovoltaic cell module configured as illustrated in FIG. 1 was manufactured.

**<Example 2>**

A photovoltaic cell module was manufactured in the same manner as described in Example 1 except that the encapsulant composition (3) and the encapsulant composition (4) were used instead of the encapsulant composition (1) and the encapsulant composition (2), respectively.

**<Comparative Example 1>**

A photovoltaic cell module configured as illustrated in FIG. 1 was manufactured in the same manner as described in Example 1 except that an EVA resin (ES2N produced by SKC Co., Ltd.) was used as an encapsulant instead of the encapsulant composition (1) prepared in Preparation Example 1 and an EVA resin (ES2N produced by SKC Co., Ltd.) was used as an encapsulant instead of the encapsulant composition (2) prepared in Preparation Example 2.
Properties of the photovoltaic cell modules manufactured in the above-descried examples and comparative example were measured by the following methods.

**1. Evaluation of power generation efficiency of photovoltaic cell module**

Power generation efficiencies of the photovoltaic cell modules manufactured in the above-descried examples and comparative example were measured using a sum simulator. To be specific, toward the upper substrates (glass plate) of the respective photovoltaic cell modules manufactured in the above-descried examples and comparative example, a light source of 1 kW was radiated for one (1) hour in the same manner, power generation amounts of the photovoltaic cell modules were measured, and power generation efficiencies were measured according to General Formula 3.

[General Formula 3]

$$\text{Power generation efficiency} = \text{power generation amount of photovoltaic cell}$$

$$\text{module/light irradiation amount} \times 100(\%)$$

**2. Evaluation on durability and reliability**

Durability and reliability of the photovoltaic cell modules manufactured in the above-described examples and comparative example under high temperature and high humidity conditions were measured by the following method. To be specific, the encapsulant compositions of Example 1 and Comparative Example 1 were coated respectively on glass plates and cured and left under a temperature of 85 °C at 85% R.H (relative humidity) for 500 hours. Then, an adhesive strength was measured by means of a peel test.

<Evaluation criteria for durability and reliability>

O: Adhesive strength of 30 gf/mm or more

X: Adhesive strength of less than 30 gf/mm

**3. Evaluation on UV resistance (yellowing resistance)**

An ultraviolet light was radiated to the photovoltaic cell modules manufactured in the above-described examples and comparative example at a temperature of 60 °C for 3 days using a Q-UVA (340 nm, 0.89 W/cm$^2$) tester as an ultraviolet irradiation device, and absorptance at a wavelength of the above ultraviolet light was measured.

<Evaluation criteria on UV resistance (yellowing resistance)>

O: After the irradiation of light, absorptance of less than 5% at a wavelength of 450 nm

X: After the radiation of light, absorptance of more than 5% at a wavelength of 450 nm

The above-described property measurement results are listed in Table 1.

[Table 1]

|  | Example 1 | Example 2 | Comparative Example 1 |
|---|---|---|---|
| Power generation efficiency | 9.8% | 9.7% | 9.3% |
| Durability and reliability | O | O | X |
| UV resistance (yellowing resistance) | O | O | X |

As shown in Table 1, in Example 1 and Example 2 according to the present invention, the durability, reliability and UV resistance (yellowing resistance) were excellent, whereas in Comparative Example 1 not according to the present invention, the durability, reliability and UV resistance (yellowing resistance) were poor. Further, in Example 1 and Example 2, the encapsulants containing light scattering particles were included, and thus the power generation efficiencies were high as compared with Comparative Example 1.

**[Description of Main Reference Numerals of Drawings]**

1,2: Photovoltaic cell modules 10: Upper substrate

11: Lower substrate 14,24: Active layers

12, 12a, 12b, 13: Encapsulants

**Claims**

**1.** A photovoltaic cell module comprising:

an upper substrate;
a lower substrate; and

a photovoltaic cell or a photovoltaic cell array that is encapsulated by an encapsulant between the upper substrate and the lower substrate,

the encapsulant comprising a first layer comprising an aryl group-containing silicone resin, a second layer comprising a light scattering particle and a third layer comprising a silicone resin or an ethylene vinyl acetate copolymer.

2. The photovoltaic cell module of claim 1, wherein the second layer comprising light scattering particles is comprised in the encapsulant so as not to be in contact with the photovoltaic cell or the photovoltaic cell array.

3. The photovoltaic cell module of claim 2, wherein the second layer comprising light scattering particles is positioned at a lower side of the encapsulant.

4. The photovoltaic cell module of claim 1, wherein the aryl group-containing silicone resin comprised in the first layer satisfies a condition of General Formula 1:

$$[\text{General Formula 1}]$$
$$X \geq 0.15$$

wherein, X represents an average molar ratio (aryl groups/silicon atoms) of the aryl groups in the aryl group-containing silicone resin with respect to the silicon atoms in the aryl group-containing silicone resin.

5. The photovoltaic cell module of claim 1, wherein the aryl group-containing silicone resin comprised in the first layer is a silicone resin represented by an average composition formula of Chemical Formula 1 and comprises a siloxane unit represented by Chemical Formula 2 or Chemical Formula 3.

[Chemical Formula 1] $(R^1R^2R^3SiO_{1/2})_a(R^4R^5SiO_{2/2})_b(R^6SiO_{3/2})_c(SiO_{4/2})_d$

[Chemical Formula 2] $(R^7R^8SiO_{2/2})$

[Chemical Formula 3] $(R^9SiO_{3/2})$

wherein, $R^1$ to $R^6$ are substituents directly bound to a silicon atom and each independently represent hydrogen, an alkyl group, an aryl group, a hydroxy group, an epoxy group, an acryl group, an isocyanate group, an alkoxy group or an alkenyl group; at least one or more of $R^1$ to $R^6$ represent an aryl group; a is between 0 and 0.6, b is between 0 and 0.8, c is between 0 and 0.8, d is between 0 and 0.4, and a+b+c+d is 1; $R^7$ and $R^8$ independently represent an alkyl group or an aryl group; $R^9$ represents an aryl group; b and c are not 0 simultaneously; and at least one of $R^7$ and $R^8$ represents an aryl group.

6. The photovoltaic cell module of claim 5, wherein the aryl groups in the aryl group-containing silicone resin are comprised in the siloxane unit represented by Chemical Formula 2 or the siloxane unit represented by Chemical Formula 3.

7. The photovoltaic cell module of claim 5, wherein the siloxane unit represented by Chemical Formula 2 is a siloxane unit represented by Chemical Formula 4 or Chemical Formula 5, and the siloxane unit represented by Chemical Formula 3 is a siloxane unit represented by Chemical Formula 6:

[Chemical Formula 4] $(MePhSiO_{2/2})$

[Chemical Formula 5] $(Ph2SiO_{2/2})$

[Chemical Formula 6] $(PhysiO_{3/2})$

wherein, Me represents a methyl group and Ph represents a phenyl group.

8. The photovoltaic cell module of claim 5, wherein the silicone resin represented by the average composition formula of Chemical Formula 1 has a weight average molecular weight in the range of from 500 to 200,000.

9. The photovoltaic cell module of claim 1, wherein the light scattering particle has a refractive index of 1.5 or more with respect to light having a wavelength of 450 nm.

10. The photovoltaic cell module of claim 1, wherein the light scattering particle comprises one or more selected from the group consisting of glass beads, alumina, titanium oxide, zirconium oxide, cerium oxide, hafnium oxide, niobium pentoxide, tantalum pentoxide, indium oxide, tin oxide, indium tin oxide, zinc oxide, silicon-based particles, zinc sulfide, barium sulfate, calcium carbonate, and magnesium oxide.

11. The photovoltaic cell module of claim 1, wherein the second layer further comprises an aryl group-containing silicone resin that satisfies a condition of General Formula 2:

$$[\text{General Formula 2}]$$

$$Y \geq 0.15$$

wherein, Y represents an average molar ratio (aryl groups/silicon atoms) of the aryl groups in the aryl group-containing silicone resin with respect to the silicon atoms in the aryl group-containing silicone resin of the second layer.

12. The photovoltaic cell module of claim 11, wherein the second layer comprises the light scattering particles in the amount of from 0.1 parts by weight to 50 parts by weight relative to 100 parts by weight of the aryl group-containing silicone resin.

13. The photovoltaic cell module of claim 11, wherein the aryl group-containing silicone resin in the second layer is a silicone resin represented by an average composition formula of Chemical Formula 7:

[Chemical Formula 7] $(R^{10}R^{11}R^{12}SiO_{1/2})_e(R^{13}R^{14}SiO_{2/2})_f(R^{15}SiO_{3/2})_g(SiO_{4/2})_h$

wherein, $R^{10}$ to $R^{15}$ are substituents directly bound to a silicon atom and independently represent hydrogen, an alkyl group, an aryl group, a hydroxy group, an epoxy group, an acryl group, an isocyanate group, an alkoxy group or an alkenyl group; at least one or more of $R^{10}$ to $R^{15}$ represent an aryl group; and e is between 0 and 0.6, f is between 0 and 0.8, g is between 0 and 0.8, h is between 0 and 0.4, and e+f+g+h is 1.

14. The photovoltaic cell module of claim 13, wherein the aryl group-containing silicone resin in the second layer comprises a siloxane unit represented by Chemical Formula 8 or a siloxane unit represented by Chemical Formula 9:

[Chemical Formula 8] $R^{16}R^{17}SiO_{2/2}$

[Chemical Formula 9] $R^{18}SiO_{3/2}$

wherein, $R^{16}$ and $R^{17}$ independently represent an alkyl group or an aryl group; at least one of $R^{16}$ and $R^{17}$ represents an aryl group; and $R^{18}$ represents an aryl group.

15. The photovoltaic cell module of claim 14, wherein the siloxane unit represented by Chemical Formula 8 is a siloxane unit represented by Chemical Formula 10 or Chemical Formula 11, and the siloxane unit represented by Chemical Formula 9 is a siloxane unit represented by Chemical Formula 12:

[Chemical Formula 10] $(MePhSiO_{2/2})$

[Chemical Formula 11] $(Ph_2SiO_{2/2})$

[Chemical Formula 12] $(PhSiO_{3/2})$

wherein, Me represents a methyl group and Ph represents a phenyl group.

16. The photovoltaic cell module of claim 13, wherein the silicone resin represented by the average composition formula of Chemical Formula 7 has a weight average molecular weight in the range of from 500 to 200,000.

**Patentansprüche**

1. Photovoltaikzellmodul, welches umfasst:

   ein oberes Substrat;
   ein unteres Substrat;
   eine Photovoltaikzelle oder eine Photovoltaikzellanordnung, die durch ein Einkapselungsmittel zwischen dem oberen Substrat und dem unteren Substrat eingekapselt ist,

   wobei das Einkapselungsmittel eine erste Schicht, die ein Arylgruppen enthaltendes Siliconharz umfasst, eine zweite Schicht umfassend ein Licht streuendes Teilchen und eine dritte Schicht umfassend ein Silikonharz oder ein Ethylenvinylacetatcopolymer umfasst.

2. Photovoltaikzellmodul nach Anspruch 1, wobei die zweite Schicht, die ein Licht streuendes Teilchen umfasst, in dem Einkapselungsmittel so umfasst ist, um nicht in Kontakt zu sein mit der Photovoltaikzelle oder der Photovoltaikzellanordnung.

3. Photovoltaikzellmodul nach Anspruch 2, wobei die zweite Schicht, die Lichtstreuteilchen umfasst, an einer unteren Seite des Einkapselungsmittels positioniert ist.

4. Photovoltaikzellmodul nach Anspruch 1, wobei das Arylgruppen enthaltende Silikonharz, das in der ersten Schicht umfasst ist, eine Bedingung der allgemeinen Formel 1 erfüllt:

$$[\text{Allgemeine Formel 1}]$$

$$X \geq 0{,}15$$

wobei X ein durchschnittliches Molverhältnis (Arylgruppen/Siliziumatome) der Arylgruppen in dem Arylgruppen enthaltenden Silikonharz in Bezug auf die Siliziumatome in dem Arylgruppen enthaltenden Silikonharz darstellt.

5. Photovoltaikzellmodul nach Anspruch 1, wobei das Arylgruppen enthaltende Silikonharz, das in der ersten Schicht umfasst ist, ein Silikonharz ist, das dargestellt ist durch eine durchschnittliche Zusammensetzungsformel der chemischen Formel 1 und eine Siloxaneinheit umfasst, die durch chemische Formel 2 oder chemische Formel 3 dargestellt ist:

   [Chemische Formel 1]     $(R^1R^2R^3SiO_{1/2})_a(R^4R^5SiO_{2/2})_b(R^6SiO_{3/2})_c(SiO_{4/2})_d$

   [Chemische Formel 2]     $(R^7R^8SiO_{2/2})$

   [Chemische Formel 3]     $(R^9SiO_{3/2})$

   wobei $R^1$ bis $R^6$ Substituenten sind, die direkt an ein Siliziumatom angebunden sind und jeweils unabhängig Wasserstoff, eine Alkylgruppe, eine Arylgruppe, eine Hydroxygruppe, eine Epoxygruppe, eine Acrylgruppe, eine Isocyanatgruppe, eine Alkoxygruppe oder eine Alkenylgruppe darstellen; wobei wenigstens eines oder mehrere der $R^1$ bis $R^6$ eine Arylgruppe darstellen; a zwischen 0 und 0,6 ist, b zwischen 0 und 0,8 ist, c zwischen 0 und 0,8 ist, d zwischen 0 und 0,4 ist und a+b+c+d 1 ist; $R^7$ und $R^8$ unabhängig eine Alkylgruppe oder eine Arylgruppe darstellen; $R^9$ eine Arylgruppe darstellt; b und c nicht gleichzeitig 0 sind; und wenigstens eines von $R^7$ und $R^8$ eine Arylgruppe darstellen.

6. Photovoltaikzellmodul nach Anspruch 5, wobei die Arylgruppen in dem Arylgruppen enthaltenden Siliconharz in der durch chemische Formel 2 dargestellten Siloxaneinheit oder der durch chemische Formel 3 dargestellten Siloxaneinheit umfasst sind.

7. Photovoltaikzellmodul nach Anspruch 5, wobei die Siloxaneinheit, die durch chemisch Formel 2 dargestellt ist, eine Siloxaneinheit ist, die durch chemische Formel 4 oder chemische Formel 5 dargestellt ist, und wobei die Siloxaneinheit, die durch chemische Formel 3 dargestellt ist, eine Siloxaneinheit ist, die durch chemische Formel 6 dargestellt ist:

[Chemische Formel 4]          $(MePhSiO_{2/2})$

[Chemische Formel 5]          $(Ph2SiO_{2/2})$

[Chemische Formel 6]          $(PhSiO_{3/2})$

wobei Me eine Methylgruppe darstellt und Ph eine Phenylgruppe darstellt.

8. Photovoltaikzellmodul nach Anspruch 5, wobei das Siliconharz, das durch die durchschnittliche Zusammensetzungsformel der chemischen Formel 1 dargestellt ist, ein Gewichtsmittelmolekulargewicht im Bereich von 500 bis 200,000 aufweist.

9. Photovoltaikzellmodul nach Anspruch 1, wobei das Licht streuende Teilchen einen Brechungsindex von 1,5 oder höher in Bezug auf Licht mit einer Wellenlänge von 450 nm aufweist.

10. Photovoltaikzellmodul nach Anspruch 1, wobei das Licht streuende Teilchen eines oder mehrere umfasst, die ausgewählt sind aus der Gruppe bestehend aus Glaskügelchen, Aluminiumoxid, Titanoxid, Zirkoniumoxid, Ceroxid, Hafniumoxid, Niobpentoxid, Tantalpentoxid, Indiumoxid, Zinnoxid, Indium-Zinn-Oxid, Zinkoxid, Teilchen auf Siliziumbasis, Zinksulfid, Bariumsulfat, Calciumcarbonat und Magnesiumoxid.

11. Photovoltaikzellmodul nach Anspruch 1, wobei die zweite Schicht ferner ein Arylgruppen enthaltendes Silikonharz umfasst, das eine Bedingung der allgemeinen Formel 2 erfüllt:

[Allgemeine Formel 2]

$$Y \geq 0,15$$

wobei Y ein durchschnittliches Molverhältnis (Arylgruppen/Siliziumatome) der Arylgruppen in dem Arylgruppen enthaltenden Silikonharz in Bezug auf die Siliziumatome in dem Arylgruppen enthaltenden Silikonharz der zweiten Schicht darstellt.

12. Photovoltaikzellmodul nach Anspruch 11, wobei die zweite Schicht die Licht streuenden Teilchen in der Menge von 0,1 Gewichtsteilen bis 50 Gewichtsteilen relativ zu 100 Gewichtsteilen des Arylgruppen enthaltenden Silikonharzes umfasst.

13. Photovoltaikzellmodul nach Anspruch 11, wobei das Arylgruppen enthaltende Silikonharz in der zweiten Schicht ein Silikonharz ist, das durch eine durchschnittliche Zusammensetzungsformel der chemischen Formel 7 dargestellt ist:

[Chemische Formel 7]          $(R^{10}R^{11}R^{12}SiO_{1/2})_e(R^{13}R^{14}SiO_{2/2})_f(R^{15}SO_{3/2})_g(SiO_{4/2})h$

$R^{10}$ bis $R^{15}$ Substituenten sind, die direkt an ein Siliziumatom angebunden sind und unabhängig Wasserstoff, eine Alkylgruppe, eine Arylgruppe, eine Hydroxygruppe, eine Epoxygruppe, eine Acrylgruppe, eine Isocyanatgruppe, eine Alkoxygruppe oder eine Alkenylgruppe darstellen; wenigstens eines oder mehrere von $R^{10}$ bis $R^{15}$ eine Arylgruppe darstellen; und e zwischen 0 und 0,6 ist, f zwischen 0 und 0,8 ist, g zwischen 0 und 0,8 ist, h zwischen 0 und 0,4 ist und e+f+g+h 1 ist.

14. Photovoltaikzellmodul nach Anspruch 13, wobei das Arylgruppen enthaltende Silikonharz in der zweiten Schicht eine durch chemische Formel 8 dargestellte Siloxaneinheit oder eine durch chemische Formel 9 dargestellte Siloxaneinheit umfasst:

[Chemische Formel 8]          $R^{16}R^{17}SiO_{2/2}$

[Chemische Formel 9]    $R^{18}SiO_{3/2}$

wobei $R^{16}$ und $R^{17}$ unabhängig eine Alkylgruppe oder eine Arylgruppe darstellen; wenigstens eines von $R^{16}$ und $R^{17}$ eine Arylgruppe darstellt; und $R^{18}$ eine Arylgruppe darstellt.

15. Photovoltaikzellmodul nach Anspruch 14, wobei die durch chemische Formel 8 dargestellte Siloxaneinheit eine durch chemisch Formel 10 oder chemische Formel 11 dargestellte Siloxaneinheit ist, und wobei die durch chemische Formel 9 dargestellte Siloxaneinheit eine durch chemische Formel 12 dargestellte Siloxaneinheit ist:

[Chemische Formel 10]    $(MePhSiO_{2/2})$

[Chemische Formel 11]    $(Ph_2SiO_{2/2})$

[Chemische Formel 12]    $(PhSiO_{3/2})$

wobei Me eine Methylgruppe darstellt und Ph eine Phenylgruppe darstellt.

16. Photovoltaikzellmodul nach Anspruch 13, wobei das Silikonharz, das durch die durchschnittliche Zusammensetzungsformel der chemischen Formel 7 dargestellt ist, ein Gewichtsmittelmolekulargewicht im Bereich von 500 bis 200,000 aufweist.

**Revendications**

1. Module de cellule photovoltaïque comprenant :

un substrat supérieur ;
un substrat inférieur ; et
une cellule photovoltaïque ou un groupe de cellules photovoltaïques encapsulées par un encapsulant entre le substrat supérieur et le substrat inférieur,
l'encapsulant comprenant une première couche comprenant une résine de silicone contenant des groupes aryle, une seconde couche comprenant une particule de diffusion de la lumière et une troisième couche comprenant une résine de silicone ou un copolymère éthylène vinyle acétate.

2. Module de cellule photovoltaïque de la revendication 1, dans lequel la seconde couche comprenant les particules de diffusion de la lumière est comprise dans l'encapsulant pour ne pas être en contact avec la cellule photovoltaïque ou le groupe de cellules photovoltaïques.

3. Module de cellule photovoltaïque de la revendication 2, dans lequel la seconde couche comprenant les particules de diffusion de la lumière est positionnée sur une partie inférieure de l'encapsulant.

4. Module de cellule photovoltaïque de la revendication 1, dans lequel la résine de silicone contenant les groupes aryle comprise dans la première couche satisfait une condition de la Formule générale 1 :

$$[\text{Formule générale}]$$

$$X \geq 0{,}15$$

dans laquelle, X représente un rapport molaire moyen (groupes aryle/atomes de silicone) des groupes aryle dans la résine de silicone contenant les groupes aryle relatif aux atomes de silicone dans la résine de silicone contenant les groupes aryle.

5. Module de cellule photovoltaïque de la revendication 1, dans lequel la résine de silicone contenant les groupes aryle comprise dans la première couche est une résine de silicone représentée par une formule de composition moyenne de la Formule chimique 1 et comprend une unité siloxane représentée par la Formule chimique 2 ou la Formule chimique 3.

[Formule chimique 1]     $(R^1R^2R^3SiO_{1/2})_a(R^4R^5SiO_{2,2})_b(R^6SiO_{3/2})_c(SiO_{4/2})_d$

[Formule chimique 2]     $(R^7R^8SiO_{2/2})$

[Formule chimique 3]     $(R^9SiO_{3/2})$

dans lesquelles $R^1$ à $R^6$ représentent des substituants directement liés à un atome de silicone et représentent chacun indépendamment l'hydrogène, un groupe alkyle, un groupe aryle, un groupe hydroxy, un groupe époxy, un groupe acryle, un groupe isocyanate, un groupe alcoxy ou un groupe alcényle ; au moins l'un de $R^1$ à $R^6$ représente un groupe aryle; ; a est compris entre 0 et 0,6, b est compris entre 0 et 0,8, c est compris entre 0 et 0,8, d est compris entre 0 et 0,4, et a+b+c+d vaut 1 ; $R^7$ et $R^8$ représentent indépendamment un groupe alkyle ou un groupe aryle ; $R^9$ représente un groupe aryle ; b et c ne valent pas simultanément 0 ; et au moins l'un de $R^7$ et $R^8$ représente un groupe aryle.

6.  Module de cellule photovoltaïque de la revendication 5, dans lequel les groupes aryle dans la résine de silicone contenant les groupes aryle sont compris dans l'unité siloxane représentée par la Formule chimique 2 ou l'unité siloxane représentée par la Formule chimique 3.

7.  Module de cellule photovoltaïque de la revendication 5, dans lequel l'unité siloxane représentée par la Formule chimique 2 est une unité siloxane représentée par la Formule chimique 4 ou par la Formule chimique 5, et l'unité siloxane représentée par la Formule chimique 3 est une unité siloxane représentée par la Formule chimique 6 :

[Formule chimique 4]     $(MePhSiO_{2/2})$

[Formule chimique 5]     $(Ph2SiO_{2/2})$

[Formule chimique 6]     $(PhSiO_{3/2})$

dans lesquelles, Me représente un groupe méthyle et Ph représente un groupe phényle.

8.  Module de cellule photovoltaïque de la revendication 5, dans lequel la résine de silicone représentée par la formule de composition moyenne de la Formule chimique 1 possède une masse moléculaire moyenne en poids comprise dans la gamme allant de 500 à 200.000.

9.  Module de cellule photovoltaïque de la revendication 1, dans lequel la particule de diffusion de la lumière possède un indice de réfraction de 1,5 ou plus élevé par rapport à la lumière ayant une longueur d'onde de 450 nm.

10.  Module de cellule photovoltaïque de la revendication 1, dans lequel la particule de diffusion de lumière comprend un ou plusieurs éléments sélectionnés dans le groupe constitué de billes de verre, d'alumine, d'oxyde de titane, d'oxyde de zirconium, d'oxyde de cérium, d'oxyde de hafnium, de pentoxyde de niobium, de pentoxyde de tantale, d'oxyde d'indium, d'oxyde d'étain, d'oxyde d'indium et d'étain, d'oxyde de zinc, de particules à base de silicium, de sulfure de zinc, de sulfate de baryum, de carbonate de calcium et d'oxyde de magnesium.

11.  Module de cellule photovoltaïque de la revendication 1, dans lequel la seconde couche comprend en outre une résine de silicone contenant des groupes aryle qui satisfait à une condition de la Formule générale 2 :

$$[\text{Formule générale 2}]$$

$$Y \geq 0{,}15$$

dans laquelle, Y représente un rapport molaire moyen (groupes aryle/atomes de silicone) des groupes aryle dans la résine de silicone contenant les groupes aryle relatif aux atomes de silicone dans la résine de silicone contenant les groupes aryle de la seconde couche.

12.  Module de cellule photovoltaïque de la revendication 11, dans lequel la seconde couche comprend les particules de diffusion de la lumière en la quantité allant de 0,1 parties en poids à 50 parties en poids relativement à 100 parties en poids de la résine de silicone contenant les groupes aryle.

**13.** Module de cellule photovoltaïque de la revendication 11, dans lequel la résine de silicone contenant les groupes aryle dans la seconde couche est une résine de silicone représentée par une formule de composition moyenne de la Formule chimique 7:

[Formule chimique 7] $(R^{10}R^{11}R^{12}SiO_{1/2})_e(R^{13}R^{14}SiO_{2/2})_r(R^{15}SiO_{3/2})g(SiO_{4/2})_h$

dans laquelle $R^{10}$ à $R^{15}$ sont des substituants directement liés à un atome de silicium et représentent indépendamment l'hydrogène, un groupe alkyle, un groupe aryle, un groupe hydroxy, un groupe époxy, un groupe acryle, un groupe isocyanate, un groupe alcoxy ou un groupe alcényle ; au moins l'un de $R^{10}$ à $R^{15}$ ou plusieurs représente(nt) un groupe aryle ; et e est compris entre 0 et 0,6, f est compris entre 0 et 0,8, g est compris entre 0 et 0,8, h est compris entre 0 et 0,4, et e+f+g+h vaut 1.

**14.** Module de cellule photovoltaïque de la revendication 13, dans lequel la résine de silicone contenant les groupes aryles dans la seconde couche comprend une unité siloxane représentée par la Formule chimique 8 ou une unité siloxane représentée par la Formule chimique 9 :

[Formule chimique 8] $R^{16}R^{17}SiO_{2/2}$

[Formule chimique 9] $R^{18}SiO_{3/2}$

dans lesquelles, $R^{16}$ et $R^{17}$ représentent indépendamment un groupe alkyle ou un groupe aryle ; au moins l'un de $R^{16}$ et de $R^{17}$ représente un groupe aryle ; et $R^{18}$ représente un groupe aryle.

**15.** Module de cellule photovoltaïque de la revendication 14, dans lequel l'unité siloxane représentée par la Formule chimique 8 est une unité siloxane représentée par la Formule chimique 10 ou la Formule chimique 11, et l'unité siloxane représentée par la Formule chimique 9 est une unité siloxane représentée par la Formule chimique 12 ;

[Formule chimique 10] $(MePhSiO_{2/2})$

[Formule chimique 11] $(Ph_2SiO_2)$

[Formule chimique 12] $(PhSiO_{3/2})$

dans lesquelles, Me représente un groupe méthyle et Ph représente un groupe phényle.

**16.** Module de cellule photovoltaïque de la revendication 14, dans lequel la résine de silicone représentée par la formule de composition moyenne de la Formule chimique 7 possède une masse moléculaire moyenne en poids comprise dans la gamme allant de 500 à 200.000.

FIGURES

Fig. 1

Fig. 2

**EP 2 669 960 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010147759 A2